# EUROPEAN PATENT APPLICATION

(11) **EP 1 906 451 A1**
(43) Date of publication of application: **02.04.2008**
(21) Application number: 06766978.8
(22) Date of filing: 20.06.2006
(51) Int. Cl.: H01L 27/14, H04N 5/335, H04N 9/07

(54) **IMAGING DEVICE**

(30) Priority: 21.07.2005 JP 2005210882; 21.07.2005 JP 2005210883; 21.07.2005 JP 2005210886
(71) Applicant: MATSUSHITA ELECTRIC INDUSTRIAL CO., LTD., Osaka 571-8501 (JP)
(72) Inventor: NISHIZAWA, Hiroshi, c/o matsushita El. Ind. Co., Ltd., Chuo-ku, Osaka-shi, Osaka 540-6319 (JP)
(74) Representative: Pautex Schneider, Nicole Véronique
(86) International application number: PCT/JP2006/312317
(87) International publication number: WO 2007/010696

(57) **Abstract**

An imaging apparatus comprises: a semiconductor imaging device having a plurality of photodiodes and a color filter; and an imaging optical system for guiding light from a subject to the semiconductor imaging device, where a diameter of an aperture (40) (41) of each photodiode of the semiconductor imaging device is determined in accordance with a wavelength of light that passes through a color filter provided on an incident surface side of the photodiode. Consequently, in a camera module using the semiconductor imaging device, image degradation in the imaging apparatus is prevented in a range where wave motion has an influence due to miniaturization of the pixel size, so that the imaging apparatus can be reduced in size and thickness.

## Description

### RELATED APPLICATIONS

This application claims the benefits of Japanese Patent Applications No. 2005-210882, No. 2005-210883, and No. 2005-210886 filed on July 21, 2005 in Japan, the contents of which are incorporated herein by reference.

### TECHNICAL FIELD

The present invention relates to an imaging apparatus using a semiconductor imaging device, and particularly to an imaging apparatus used for a portable terminal, a portable telephone, or other small terminals.

### BACKGROUND ART

Conventionally, as described in Japanese Patent Laid-Open Application No. 2004-327914, an imaging apparatus using a semiconductor imaging device comprises an imaging optical system such as a lens, and a semiconductor imaging device such as a CCD. The imaging apparatus would convert light incident from a subject through the imaging optical system to an electrical signal by means of the semiconductor imaging device, and capture a picture. With portable equipment getting smaller, imaging apparatuses have also been required to be smaller and lighter than ever before. For this purpose, the thickness of an imaging apparatus would be reduced by making each component of the imaging apparatus as thin as possible.

Imaging apparatuses have been oriented towards a shift to a high pixel count and towards size reduction. An image-forming optical system would usually be designed so that the circle of least confusion would be the same size as a pixel. With a further move to size reduction and to a high pixel count, they are predicted to enter a region where the wave nature of light has to be considered in addition to ray tracing using Snell's law or the like.

Japanese Patent Laid-Open Application No. 2004-200231 indicates that a wave-optics effect need be considered, for example, at the wavelength of red light (0.650 µm) when an aperture of a photodiode is 1µm or less. The application also suggests that an electrode for vertical transmission of a signal from a pixel is provided with a red sensitivity range.

Published Japanese Translation of PCT International Application for Patent Application No. 2002-513145 discloses a device having a form in which photodiodes for different colors are arranged in the thickness direction of a semiconductor substrate. The application discloses that light having a long wavelength reaches deeper in a semiconductor base than light having a short wavelength.

### DISCLOSURE OF THE INVENTION

### Problems to be solved by the invention

As described above, conventional imaging apparatuses have reduced the size of their components in order to reduce the size and thickness of themselves, and have also attempted to improve the performance of their image-forming optical systems by using aspherical glass lenses or the like.

However, further miniaturization of pixels for reducing the size of semiconductor imaging devices to accommodate a high pixel count hinders application of already developed technologies, and consequently there has arisen a need for a new breakthrough. For example, there has arisen a need to consider a wave-optics effect disclosed in Japanese Patent Laid-Open Application No. 2004-200231.

On the other hand, pixels for each color filter are usually arranged in two dimensions in conventional imaging apparatuses, and the Bayer array or the like is well known, for example. There are also many reading methods and color correction methods for the array. There is a demand for a small, thin, and high-pixel-count imaging apparatus that can make effective use of these resources.

A purpose of the invention made in the above-mentioned background is to provide an imaging apparatus that can be small, thin, and of a high pixel count.

### Means for solving the problems

An imaging apparatus of the invention comprises: a semiconductor imaging device having a plurality of photodiodes and a color filter; and an imaging optical system for guiding light from a subject to the semiconductor imaging device, where a diameter of an aperture of each photodiode of the semiconductor imaging device is determined in accordance with a wavelength of light that passes through a color filter provided on an incident surface side of the photodiode and reaches the incident surface.

In this configuration, when the size of the imaging apparatus is reduced, an aperture of a photodiode for a red pixel on the long-wavelength side that is susceptible to a wave-optics effect can be made larger in diameter than an aperture of a photodiode for another wavelength. Reduction in output can be prevented by avoiding a wave-optics effect even for a photodiode sensitive on the long-wavelength side, and size reduction of the imaging apparatus can be achieved.

The above-described imaging apparatus comprises an optical filter placed between the semiconductor imaging device and the imaging optical system, where a diameter of an aperture of each photodiode of the semiconductor imaging device is determined in accordance with an angle of incidence of light that enters an area on the optical filter corresponding to the photodiode.

This configuration can reduce image degradation caused by an increase in the angle of incidence. An optical filter has a property that the optical filter's half-value wavelength shifts to the short-wavelength side as the angle of incidence becomes larger. Following this, attenuation of red on the long-wavelength side becomes larger, and therefore image degradation progresses. However, the image degradation can be prevented by making an aperture of a photodiode for a red pixel on the long-wavelength side larger in diameter than an aperture of a photodiode for light of another wavelength.

In the above-described imaging apparatus, pixels on a same line of the semiconductor imaging device are equal in height.

In this configuration, the size of pixels on each line is the same in the height direction. Consequently, routing of an internal electrode of the semiconductor imaging device is facilitated, and a degree of flexibility in layout design can be increased.

An imaging apparatus of the invention comprises: a semiconductor imaging device having a plurality of photodiodes and a color filter; and an imaging optical system for guiding light from a subject to the semiconductor imaging device, where the semiconductor imaging device, on an opposite side of an incident surface of at least part of the plurality of photodiodes, has an auxiliary photodiode for detecting light that has passed through the photodiode.

In this configuration, light that has passed through a photodiode on the incident surface side enters the auxiliary photodiode. Consequently, outputs from each photodiode are added to each other, and the output from one pixel can be increased. The number of auxiliary photodiodes is not limited to one, and there may be any number of them. If the auxiliary photodiode is placed for a photodiode, among the plurality of photodiodes, corresponding to a red pixel on the long-wavelength side that is susceptible to a wave-optics effect when the size of the imaging apparatus is reduced, the sensitivity of the photodiode sensitive on the long-wavelength side can be increased, reduction in output caused by a wave-optics effect can be compensated, and size reduction of the imaging apparatus can be achieved. Since long-wavelength light generally reaches deeper into a semiconductor chip, the output can be efficiently increased even if photodiodes are arranged in piles, and the sensitivity to long-wavelength light that is susceptible to a wave-optics effect can be increased.

In the above-described imaging apparatus, a size of the auxiliary photodiode is determined in accordance with a wavelength of light that passes through the color filter provided on an incident surface side of the photodiode and reaches the incident surface.

This configuration can determine how much the auxiliary photodiode increases the sensitivity, in accordance with a wavelength of light that is transmitted by the color filter. For example, since a photodiode provided with a color filter which transmits long-wavelength light is highly susceptible to a wave-optics effect, the auxiliary photodiode is made large in size to increase the degree of increase in the sensitivity. Since a photodiode provided with a color filter which transmits short-wavelength light is less susceptible to a wave-optics effect, the auxiliary photodiode is made small in size to decrease the degree of increase in the sensitivity. In this way, a wave-optics effect, which differs depending on wavelength, can be compensated for every wavelength, and the sensitivity of the whole imaging apparatus can be balanced.

The above-described imaging apparatus comprises an optical filter placed between the semiconductor imaging device and the imaging optical system, where a size of the auxiliary photodiode is determined in accordance with an angle of incidence of light that enters an area on the optical filter corresponding to the photodiode.

This configuration can reduce image degradation caused by an increase in the angle of incidence. An optical filter has a property that the optical filter's half-value wavelength shifts to the short-wavelength side as the angle of incidence becomes larger. Following this, attenuation of red on the long-wavelength side becomes larger, and therefore image degradation progresses. However, the image degradation can be compensated by making a photodiode for a red pixel on the long-wavelength side larger in size than a photodiode for light of another wavelength.

An imaging apparatus of the invention comprises: a semiconductor imaging device having a plurality of photodiodes and a color filter; and an imaging optical system for guiding light from a subject to the semiconductor imaging device, where the semiconductor imaging device, on an opposite side of an incident surface of at least part of the plurality of photodiodes, has a reflective layer for reflecting light that has passed through the photodiode.

In this configuration, light that has passed through a photodiode is reflected by the reflective layer and reenters the photodiode. Consequently, the output from the photodiode can be increased. If the reflective layer is placed for a photodiode, among the plurality of photodiodes, corresponding to a red pixel on the long-wavelength side that is susceptible to a wave-optics effect when the size of the imaging apparatus is reduced, the sensitivity of the photodiode sensitive on the long-wavelength side can be increased, reduction in output caused by a wave-optics effect can be compensated, and size reduction of the imaging apparatus can be achieved. Since long-wavelength light generally reaches deeper into a semiconductor chip, the output can be efficiently increased even if the reflective layer is placed on the opposite side of an incident surface of a photodiode, when the color filter transmits long-wavelength light. Consequently, the sensitivity to long-wavelength light that is susceptible to a wave-optics effect can be increased.

In the above-described imaging apparatus, a size or reflectance of the reflective layer is determined in accordance with a wavelength of light that passes through the color filter provided on an incident surface side of the photodiode and reaches the incident surface.

This configuration can determine how much the sensitivity is increased, by changing the size or reflectance of the reflective layer in accordance with a wavelength of light that is transmitted by the color filter. For example, since a photodiode provided with a color filter which transmits long-wavelength light is highly susceptible to a wave-optics effect, the reflective layer is made large in size or reflectance to increase the degree of increase in the sensitivity. Since a photodiode provided with a color filter which transmits short-wavelength light is less susceptible to a wave-optics effect, the reflective layer is made small in size or reflectance to decrease the degree of increase in the sensitivity. In this way, a wave-optics effect, which differs depending on wavelength, can be compensated for every wavelength, and the sensitivity of the whole imaging apparatus can be balanced.

In the above-described imaging apparatus, the reflective layer is formed of a silvery-white metal.

This configuration allows the reflective layer to be applied by a simple process. The use of a silvery-white metal can maintain the reflectance of the reflective layer nearly constant in visible light region, and achieves good color reproducibility. Moreover, the configuration can shield unnecessary incident light, such as near infrared light in particular, from the backside of the semiconductor imaging device, and can reduce image degradation caused by unnecessary light.

In the above-described imaging apparatus, the reflective layer is formed of a semiconductor.

In this configuration, the reflective layer can be formed by changing the reflectance by means of a doping material, and therefore the reflective layer can be formed in a normal diffusion process without changing the process. Additionally, a multilayer reflective layer can be formed easily.

The above-described imaging apparatus comprises an optical filter placed between the semiconductor imaging device and the imaging optical system, where a size or reflectance of the reflective layer is determined in accordance with an angle of incidence of light that enters an area on the optical filter corresponding to the photodiode.

This configuration can reduce image degradation caused by an increase in the angle of incidence. An optical filter has a property that the optical filter's half-value wavelength shifts to the short-wavelength side as the angle of incidence becomes larger. Following this, attenuation of red on the long-wavelength side becomes larger, and therefore image degradation progresses. However, the image degradation can be prevented by making a reflective layer for a red pixel on the long-wavelength side larger in size or higher in reflectance than a reflective layer for light of another wavelength.

The above-described imaging apparatus comprises a three-dimensional substrate for containing the semiconductor imaging device, the three-dimensional substrate not transmitting visible light and near infrared light.

In this configuration, the semiconductor imaging device is contained inside the three-dimensional substrate not transmitting visible light and near infrared light. Consequently, there is no need to provide a shield member for shielding the imaging apparatus from light when it is mounted in a portable telephone or other portable equipment, and therefore the equipment can be reduced in size. In addition, since the semiconductor imaging device and the imaging optical system can be fixed to the three-dimensional substrate, the workability improves.

In the above-described imaging apparatus, a pixel pitch of the semiconductor imaging device is 2 micrometers or less.

An aperture of a photodiode of a semiconductor imaging device is about half as large in diameter as a pixel pitch. So, when a pixel pitch is two micrometers or less, its aperture becomes smaller in diameter in association with that, and a wave-optics effect causes a reduction in output. In the configuration of the invention, an aperture through which long-wavelength light enters, causing the output reduction problem, is made large in diameter, or the auxiliary photodiode or the reflective layer is provided. Consequently, the sensitivity of the photodiode can be increased, and the output reduction can be prevented also on the long-wavelength side.

A portable telephone apparatus of the invention comprises the above-described imaging apparatus.

In this configuration, as in the case of the imaging apparatus of the invention, reduction in output can be prevented by avoiding a wave-optics effect even for a photodiode sensitive on the long-wavelength side, and size reduction of the portable telephone apparatus can be achieved. The sensitivity of the photodiode sensitive on the long-wavelength side can be improved, reduction in output caused by a wave-optics effect can be compensated, and size reduction of the portable telephone apparatus can be achieved.

A semiconductor imaging device of the invention comprises: a plurality of photodiodes for converting incident light to an electrical signal; and a color filter provided on an incident surface side of a photodiode, where a diameter of an aperture of each of the photodiodes is determined in accordance with a wavelength of light that passes through the color filter provided on an incident surface side of the photodiode and reaches the incident surface.

In this configuration, as in the case of the imaging apparatus of the invention, reduction in output can be prevented by avoiding a wave-optics effect even for a photodiode sensitive on the long-wavelength side, and size reduction of the semiconductor imaging device can be achieved.

A semiconductor imaging device of the invention comprises: a plurality of photodiodes for converting incident light to an electrical signal; a color filter provided on an incident surface side of a photodiode; and an auxiliary photodiode placed on an opposite side of an incident surface of at least part of the plurality of photodiodes, the auxiliary photodiode having a size according to a wavelength of transmitted light incident from the color filter to the photodiode.

In this configuration, as in the case of the imaging apparatus of the invention, light that has passed through a photodiode on the incident surface side enters the auxiliary photodiode. Consequently, outputs from each photodiode are added to each other, and the output from one pixel can be increased. Additionally, a wave-optics effect, which differs depending on wavelength, can be compensated for every wavelength, and the sensitivity of the whole semiconductor imaging device can be balanced.

A semiconductor imaging device of the invention comprises: a plurality of photodiodes for converting incident light to an electrical signal; a color filter provided on an incident surface side of a photodiode; and a reflective layer placed on an opposite side of an incident surface of at least part of the plurality of photodiodes, the reflective layer having a size or reflectance according to a wavelength of transmitted light incident from the color filter to the photodiode.

In this configuration, as in the case of the imaging apparatus of the invention, light that has passed through a photodiode is reflected by the reflective layer and reenters the photodiode. Consequently, the output from the semiconductor imaging device can be increased. Additionally, a wave-optics effect, which differs depending on wavelength, can be compensated for every wavelength, and the sensitivity of the whole semiconductor imaging device can be balanced.

There are other aspects of the invention as described below. This disclosure of the invention therefore intends to provide part of the invention and does not intend to limit the scope of the invention described and claimed herein.

### BRIEF DESCRIPTION OF THE DRAWINGS

Figure 1 shows an arrangement of a semiconductor imaging device in an embodiment;
Figure 2 is a perspective view showing an imaging apparatus of the embodiment;
Figure 3 is a cross section of the imaging apparatus cut along III-III;
Figure 4 is an enlarged view of part IV of the imaging apparatus;
Figure 5 shows a relation between an angle of incidence and a half-value wavelength of an optical filter in the embodiment;
Figure 6 is an enlarged cross section of one pixel of the semiconductor imaging device;
Figure 7 shows a sensitivity characteristic of a photodiode versus wavelength in the embodiment;
Figure 8 shows a sensitivity characteristic of the semiconductor imaging device versus pixel size and wavelength in the embodiment;
Figure 9 shows a relation between the pixel size and the number of pixels of the semiconductor imaging device;
Figure 10 shows an arrangement of a semiconductor imaging device;
Figure 11 is an enlarged cross section of one pixel of a semiconductor imaging device;
Figure 12 shows a sensitivity characteristic of a photodiode versus wavelength in an embodiment;
Figure 13 is an enlarged cross section of one pixel of a semiconductor imaging device; and
Figure 14 shows a sensitivity characteristic of a photodiode versus wavelength in an embodiment.

### BEST MODE OF EMBODYING THE INVENTION

The following is a detailed description of the invention. It will be understood that the embodiments described below are only examples of the invention, and the invention can be changed in various aspects. Therefore, the specific configurations and functions disclosed below do not limit the scope of the claims.

Now, embodiments of the invention will be described with reference to the drawings.

### (First embodiment)

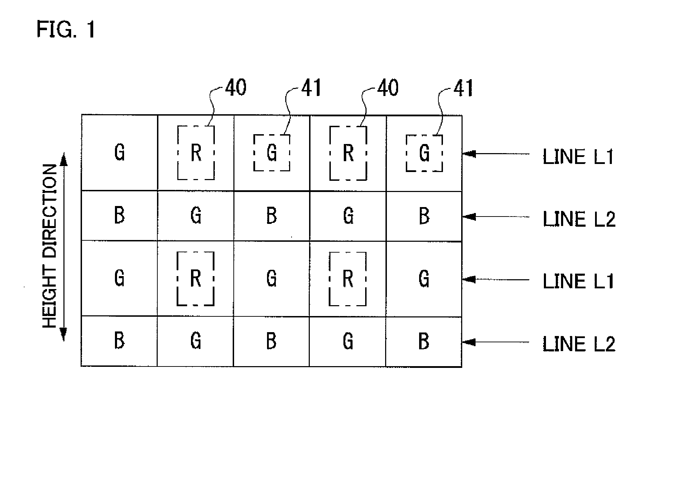

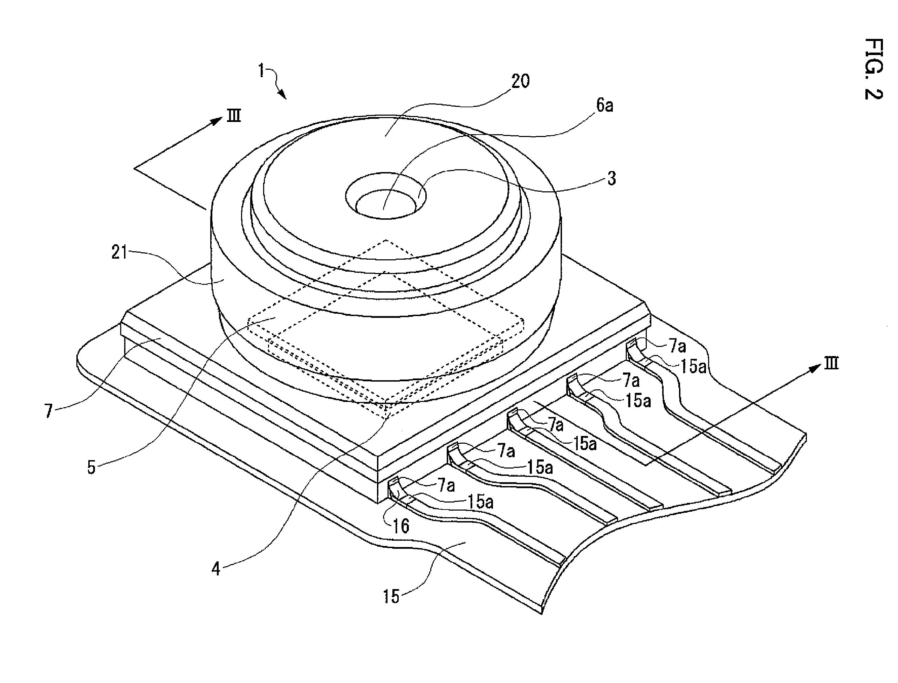

Figure 1 illustrates a semiconductor imaging device used in an imaging apparatus of this embodiment. In the description of the embodiment, a general configuration of the imaging apparatus comprising the semiconductor imaging device will first be described with reference to Figure 2 and the following figures, and then a configuration of the semiconductor imaging device will be described. The configuration of the semiconductor imaging apparatus described with reference to Figures 2 to 5 is common to all embodiments.

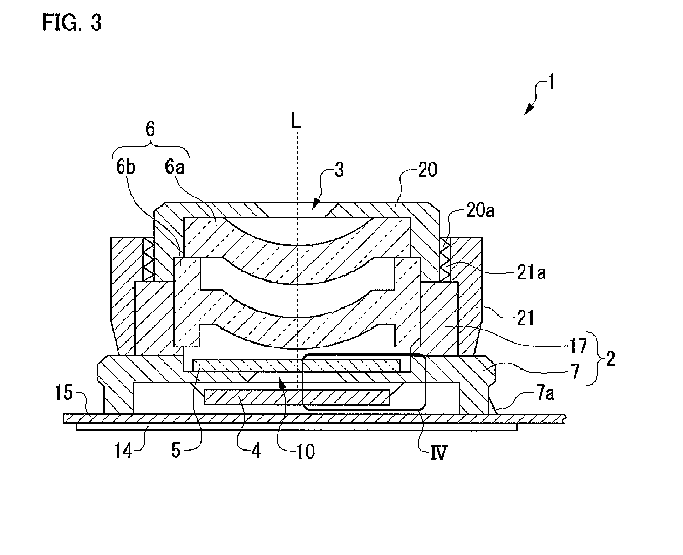

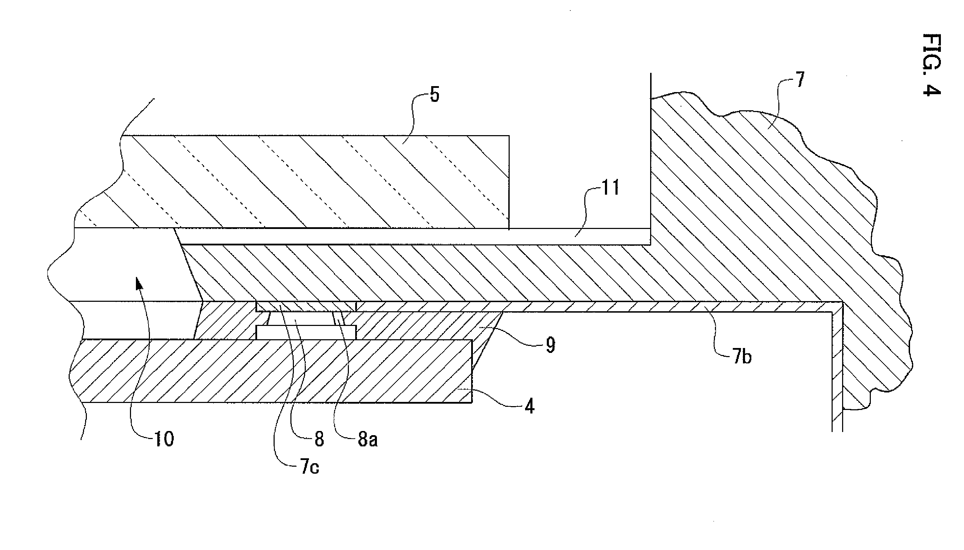

Figure 2 is a perspective view showing an imaging apparatus 1 of a first embodiment of the invention; Figure 3 is a cross section of the imaging apparatus 1 of Figure 2 viewed from the III-III direction; and Figure 4 is an enlarged view of part IV in Figure 3.

As shown in Figure 3, the imaging apparatus 1 comprises: aspherical lenses 6a and 6b arranged along an optical axis L; an optical filter 5; a semiconductor imaging device 4; a three-dimensional substrate 2 holding these components; and a printed circuit board (FPC) 15 connected to the three-dimensional substrate 2. On an undersurface of the FPC 15, metallic foil 14 is placed for preventing visible light and infrared light from entering the semiconductor imaging device 4 from the undersurface. In the embodiment, the three-dimensional substrate 2 plays both a role to fix the semiconductor imaging device 4 and a role as a retaining member for retaining the optical filter 5. The three-dimensional substrate 2 comprises a cylindrical lens barrel portion 17 and a base portion 7 continuing to an end face of the lens barrel portion 17. In the description below, the side of the lens barrel portion 17 is called the upward direction, and the side of the base portion 7 is called the downward direction.

First, the three-dimensional substrate 2 will be described. The lens barrel portion 17 is located on a top surface of the base portion 7, extending up and down. The base portion 7 is provided with a depression formed in the center of the undersurface thereof. A rectangle through hole 10 is also formed on the base portion 7. The through hole 10 corresponds to an imaging area of the semiconductor imaging device 4.

The three-dimensional substrate 2 is constructed of glass-reinforced PPA (polyphthalamide resin) or the like, and is made black to prevent visible light from passing therethrough from the outside. Carbon black or the like mixed with pellets is used for the three-dimensional substrate 2, and the light transmissivity is 0.5% or less. While it is desirable to be able to also shield light of a wavelength longer than that of visible light, the light transmissivity can be selected as appropriate in accordance with properties of the semiconductor imaging device 4 to be used, in consideration of the sensitivity in the infrared region.

In the barrel of the lens barrel portion 17, two aspherical lenses 6a and 6b whose optical properties are different from each other (hereinafter abbreviated as lens) are fitted in a lens holder 20 so as to maintain a certain positional relationship, comprising a lens 6. The lens holder 20 is fixed via an adjustment ring 21 to the outside of the lens barrel portion 17 by means of an adhesive or the like. The adjustment ring 21 is placed outside the lens holder 20. A thread portion 20a provided on the lens holder 20 and a thread portion 21 a provided on the adjustment ring 21 screw together so that the lens holder 20 and the adjustment ring 21 are fixed to each other.

The lens holder 20 is formed with an iris 3 for bringing light into the lens barrel portion 17. The aperture of the iris 3 becomes narrow toward the inside of the lens barrel portion 17. In this configuration, light entering the inside of the lens barrel portion 17 impinges on the wall surface of the iris 3 and scatters, which alleviates a phenomenon in which scattered light enters the lens. This can reduce unnecessary light entering the lens, and can reduce occurrence of a ghost.

A resin satisfying a required refractive index, required transmissivity, or other required optical properties is used for the lens 6. For example, a ZEON Corporation product whose trade name is ZEONEX (registered trademark) can be used. The two-piece-structure lens 6 uses a so-called pan-focus feature where images are formed farther than a certain distance. In the embodiment, the lens 6 is adjusted so that a subject farther than about 30 cm is brought to a focus. These structure and properties can be selected as appropriate.

The optical filter 5 is mounted on the top surface of the base portion 7 where the through hole 10 is formed, so as to cover the through hole 10. The optical filter 5 cuts off unnecessary infrared light, and transmits light having wavelengths in the visible region. A crystal filter, or a glass filter coated with a coating called IR coating is used as the optical filter 5. In the embodiment, borosilicate glass is used as a base material of the optical filter 5 to cut off ultraviolet light. An IR (infrared) cut coating is applied to one side of the base material, and an anti-reflective AR (anti reflection) coating is applied to the other side. The IR coating is formed, for example, by evaporation of silicon dioxide (SiO₂), titanium oxide (Ti O₂), and the like onto glass. The AR coating is formed, for example, by evaporation of magnesium fluoride (MgF₂), titanium oxide (Ti O₂), zirconium oxide (ZrO₂), and the like onto glass. The film structure and number of layers of the IR cut coating and AR coating can be selected as appropriate in accordance with the property of suppressing transmission and reflection in the visible light region and a region outside thereof.

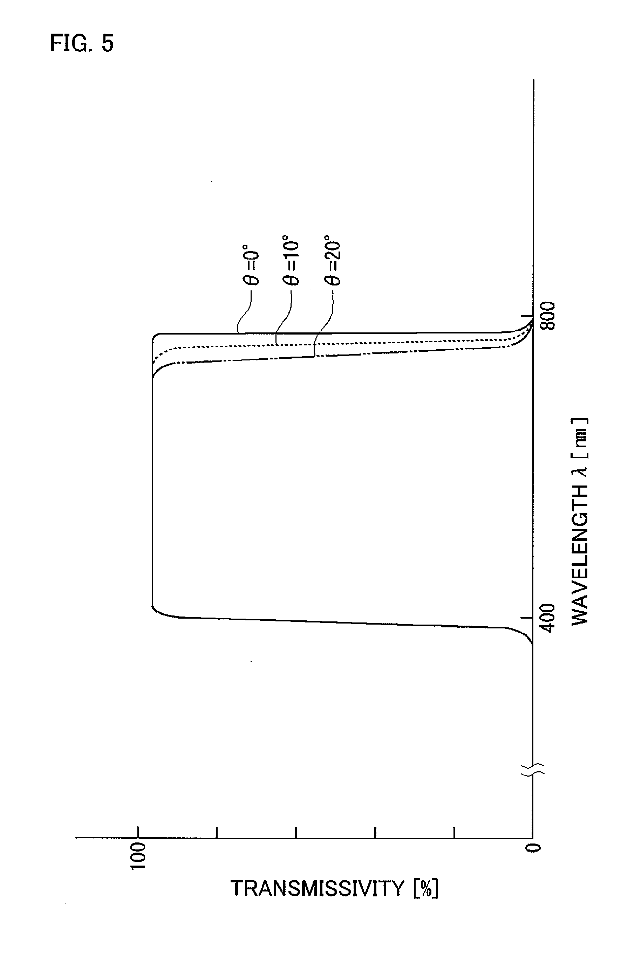

Figure 5 shows spectral characteristics of the optical filter 5 in the embodiment. The transmissivity is about 93% or higher in the visible light region of wavelengths from about 400 nm to 750 nm, and is made sufficiently low in the other bands. The spectral characteristics can also be changed as appropriate. The provision of the optical filter 5 reduces the occurrence of noise caused by light other than visible light incident on the semiconductor imaging device 4.

A groove 11 is formed on the surface on which the optical filter 5 is mounted (see Figure 4). This lets air escape through the groove 11 at the time of manufacturing the imaging apparatus 1, the air expanding due to heat applied from outside for curing an adhesive or the like.

The semiconductor imaging device 4, a not-shown chip component, and the like are mounted on the undersurface of the base portion 7 where the through hole 10 is formed (see Figure 4). A connection land 7c for mounting the bare semiconductor imaging device 4 and a bump 8 of the semiconductor imaging device 4 are bonded together with an electrically conductive adhesive 8a, and are sealed with a sealant 9. A copper undercoat, nickel, and a gold wiring pattern 7b are formed on the undersurface of the base portion 7 by electroless plating. The connection land 7c and a terminal portion 7a provided on the outside of the base portion 7 of the three-dimensional substrate 2 (see Figure 2) are electrically connected by the wiring pattern 7b. The terminal portion 7a is connected by solder 16 to a land 15a for connecting to the FPC 15. A picture signal obtained from the semiconductor imaging device 4, a not-shown chip component, and the like and electrical signals from outside such as a control signal and power supply are sent and received via the wiring pattern 7b.

The semiconductor imaging device 4 will be described next. The semiconductor imaging device 4 is a 114-inch SXGA CCD sensor of about 1.3 megapixels, and converts incident light to a required electrical signal. The semiconductor imaging device 4 has a picture frame with an aspect ratio of 4:3, and outputs an image signal of 15 frames per second.

The semiconductor imaging device 4 is electrically connected by SBB (stud bump bonding) to the connection land 7c provided on the three-dimensional substrate 2. An output from the semiconductor imaging device 4 is led via the wiring pattern 7b to the terminal portion 7a provided on the base portion 7 to connect to the external FPC 15. The above is a description of a configuration of the semiconductor imaging apparatus 1, the configuration being common to all embodiments.

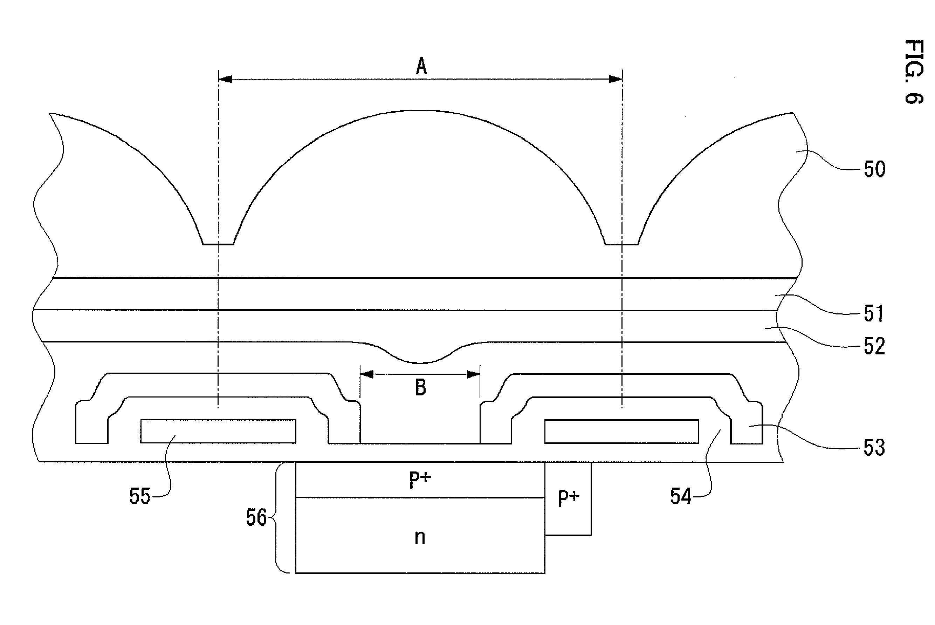

Figure 6 is an enlarged view showing one pixel of the semiconductor imaging device 4. As shown in Figure 6, a microlens 50, a color filter 51, an inner lens and protection film 52, an Al wiring and mask 53, an insulating layer 54, polysilicon 55, and the like are provided on the light incident side of a photodiode 56.

The microlens 50 collects light transmitted through the optical filter 5 and lets the light enter the photodiode 56. As the microlens 50 is away from a center toward a periphery of the semiconductor imaging device 4, the position of a center of the microlens 50 is shifted toward the center of the semiconductor imaging device 4. This is a method called scaling. Scaling prevents degradation of the properties of the photodiode 56 at the periphery of the semiconductor imaging device 4.

A pitch of the microlens 50 (dimension A in the figure) is called pixel pitch. An aperture portion of the Al wiring and mask (dimension B in the figure) corresponds to an aperture dimension for the photodiode 56. Usually, the dimension B is set to about half the dimension A.

The color filter 51 is a primary color filter comprising a filter that transmits light of a wavelength corresponding to red (R), a filter that transmits light of a wavelength corresponding to blue (B), and a filter that transmits light of a wavelength corresponding to green (G). Since Figure 6 illustrates one pixel, the color filter 51 transmits a wavelength corresponding to one of R, G, and B. The provision of the color filter 51 allows the photodiode 56 to pick up an RGB color signal as an output.

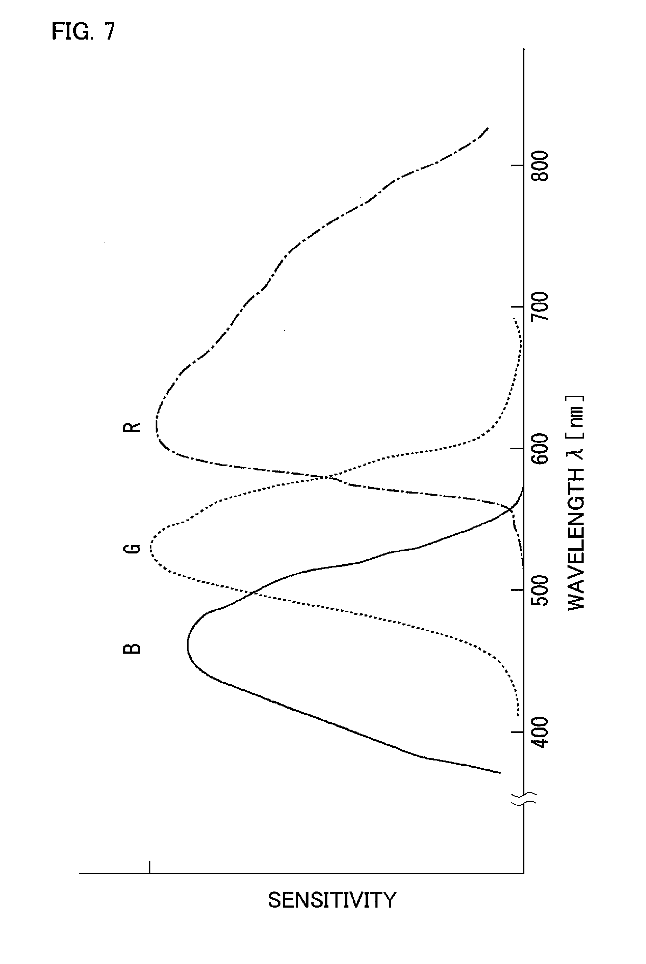

Figure 7 shows a sensitivity characteristic of the photodiode 56 versus wavelength. The horizontal axis represents wavelength, and the vertical axis represents the sensitivity. As shown in Figure 7, the photodiode is sensitive up to the near infrared region.

Since long-wavelength light is hard to attenuate, consideration is required also for light entering from the backside of the device. In the embodiment, the metallic foil 14 provided on the backside of the FPC 15 prevents the entrance of visible light and infrared light. As for sensitivities to each color, sensitivity characteristic values are integrated and compared. The sensitivities vary depending on properties of color filters, characteristics of pigmentary coloring matter to be used, and the like.

The semiconductor imaging device 4 of the embodiment will be described next with reference to Figure 1. In the embodiment, pixel dimensions in the height direction are changed for each line as shown in Figure 1. The side in the height direction of pixels in line L1 where G and R are arranged is made longer than the side in the height direction of pixels in line L2 where B and G are arranged. For example, the side in the height direction of pixels in line L2 where B and G are arranged is made 1.5 *µ*m, and the side in the height direction of pixels in line L1 where G and R are arranged is made 2.0 *µ*m. By making longer as above the side in the height direction of pixels in line L1 where G and R are arranged, the aperture of the photodiode 56 in line L1 where G and R are arranged can be enlarged.

In Figure 1, aperture portions of the photodiodes 56 are schematically indicated by chain lines. As shown in Figure 1, an aperture portion has a rectangular shape. The diameter of each aperture portion is determined in accordance with a wavelength of light that passes through the color filter 51. That is, an aperture is made larger in diameter than a wavelength of light that passes through the color filter 51. Since a wavelength of light that passes through the color filter 51 is longer for an R pixel than for a G pixel, an aperture portion 40 of an R pixel is larger than an aperture portion 41 of a G pixel.

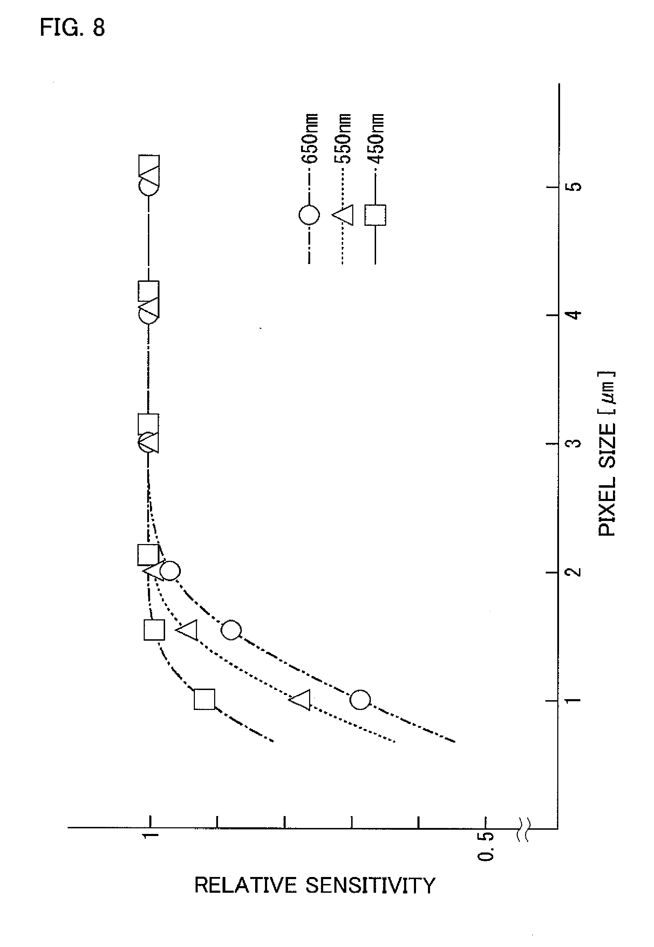

Figure 8 is a graph, obtained by a simulation, showing a sensitivity characteristic of the semiconductor imaging device versus the pixel size and each wavelength. In Figure 8, the horizontal axis represents the pixel size, and the vertical axis represents a relative value of the output from a photodiode. The pixel size means the length of a side of a square pixel. For example, 2 µm represents a square pixel whose side is 2 µm. Photodiodes having a form in which the aperture portion is about half the size of the pixel are used.

Figure 8 indicates that, when the pixel size is 1.5 *µ*m, the sensitivity to 650 nm which is near the center of the sensitivity of R decreases by about 15%, and the sensitivity to 550 nm which is near the center of the sensitivity of G decreases by about 5%. It can thus be understood that the degradation in sensitivity can be prevented and good image quality can be obtained if the aperture is made about 15% larger for an R pixel and about 5% larger for a G pixel. Since degradation of output affected by the wave nature also decreases by enlarging the aperture, an actual aperture can be made a little smaller than these values, and it is also desirable that an actual aperture is selected as appropriate in consideration of properties as the imaging apparatus 1. As for a B pixel, since the degradation in sensitivity is about 2% when the size of the pixel is 1.5 µm, the aperture need not be enlarged. While the pixel size is changed depending on the line of the pixel in the embodiment, it is only required to enlarge the aperture in diameter so as to deal with a reduction in output from the photodiode, and the aperture is not limited to the embodiment. It is also obvious that the method can be selected as appropriate in accordance with the process of the semiconductor imaging device. According to the embodiment, even when the pixel size is 1.5 µm, the sensitivity can be made almost the same for R, G, and B, and image degradation can be prevented. The above is a description of a configuration of the imaging apparatus 1 of the embodiment.

A relation between the pixel size and sensitivity of the semiconductor imaging device will be described next prior to a description of advantages of the imaging apparatus 1 of the invention.

As can be seen from Figure 8, the relative sensitivity to long wavelengths decreases remarkably as the pixel size gets smaller. The cause of this is thought to be that properties of light as a wave become nonnegligible when the pixel size is small so that the aperture portion of the photodiode is about the same size as the wavelength. It is thought that properties of light as a wave is negligible when the pixel size is 2.5 µm or larger, but that the sensitivity of a pixel corresponding to long wavelengths decreases and image degradation occurs when the pixel size is 2 *µ*m or smaller. The pixel size determines limits in reducing the size and thickness of the imaging apparatus.

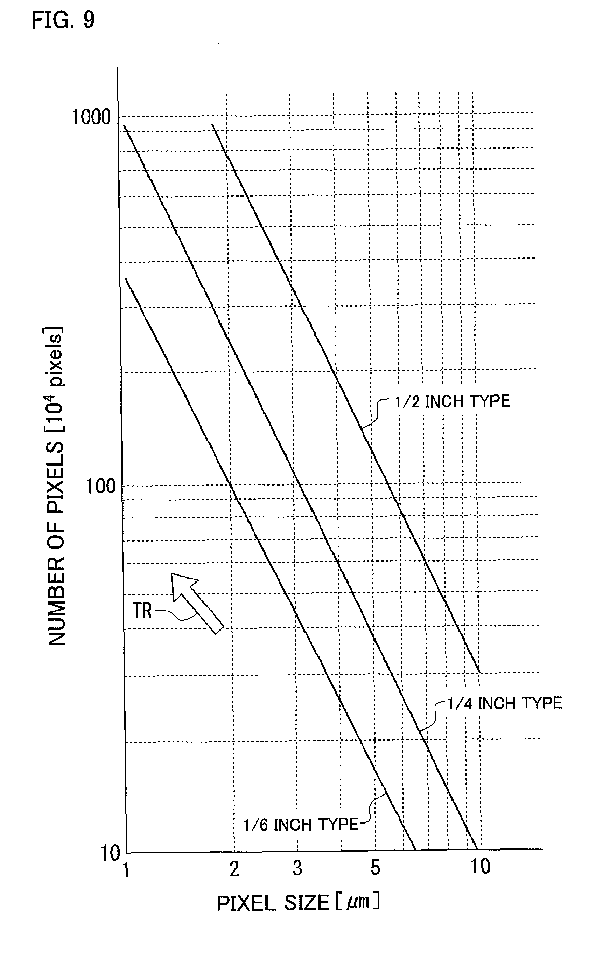

Figure 9 shows a relation between the pixel size and the number of pixels of the semiconductor imaging device by size of the imaging apparatus. The horizontal axis represents the pixel size, and the vertical axis represents the number of pixels. It can be seen from Figure 9 that the pixel size tends to get smaller and the number of pixels tends to increase as the size of the imaging apparatus gets smaller. An arrow TR in the figure indicates a trend of the apparatus. Imaging apparatus of 1-megapixei class have conventionally been from about 1/2 to 1/3-inch (expressed in inch), and are now realized as a 1/4-inch type. If the size reduction continues further in the future and a 1-megapixel device is realized as a 1/6-inch type, the pixel size will be about 2 µm. Consequently, the above-mentioned image degradation problem attributable to properties of light as a wave is expected to surface.

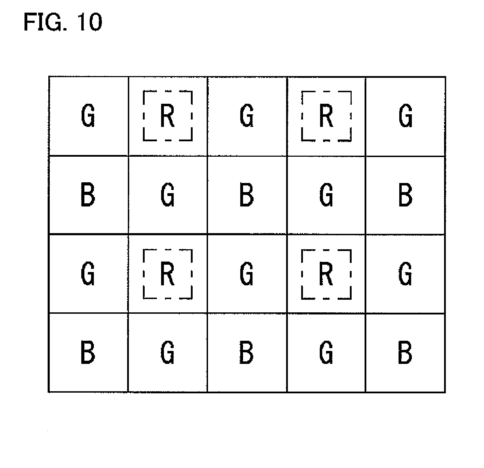

Advantages of the imaging apparatus 1 of the embodiment will be described in the following. Unlike a conventional so-called Bayer-arrangement semiconductor imaging device shown in Figure 10 where the same size square pixels are arranged uniformly, the size of pixels in the imaging apparatus 1 of the embodiment is changed in accordance with wavelengths in which the photodiode 56 is sensitive. Specifically, the pixel size is made larger for the photodiode 56 that is sensitive in long wavelengths, so that the aperture portion is made larger. The aperture portion made larger in size than the wavelengths of light can prevent the decrease in sensitivity attributable to properties of light as a wave. The pixel size is made smaller for lines that do not include R pixels for long wavelengths, and thereby the semiconductor imaging device 4 can be reduced in size.

The semiconductor imaging device of the embodiment uses a Bayer-arrangement array, and therefore conventional techniques such as a reading method, color correction, and interpolation can be applied. Consequently, the efficiency of development can be improved, and various know-how can also be inherited and applied.

The following variations can also be made to the first embodiment. While an example in which the pixel size is changed in a Bayer array has been described in the embodiment, the philosophy of the invention can be applied to an imaging apparatus having another array and an appropriate modification can be made thereto. While the aperture of the photodiode 56 is rectangular in the embodiment, the aperture can be modified to an ellipse, a circle, a hexagon, or the like.

While an example in which pixels of the same color have apertures of the same size has been described in the embodiment, the size of apertures may be changed for pixels of the same color. For example, as for G pixels whose sensitivity decreases by about 5% at near the center 550 nm in the above embodiment, large apertures and small apertures may be combined so as to improve the sensitivity by 5% as a whole.

In consideration that the half-value wavelength on the long-wavelength side shifts in value to the short-wavelength side in accordance with the angle of incidence on the optical filter 5, there may be a configuration in which apertures of surrounding pixels of the semiconductor imaging device 4 where the angle of incidence on the optical filter 5 is larger are increased in diameter compared to the near center. This point will be described in detail.

Since the optical filter 5 is a reflection type as described before, a multilayer film is provided on its one side. As the angle of incidence increases, the optical path length gets relatively longer in the multilayer film. The increase in the angle of incidence is therefore considered equivalent to thickening of the multilayer film, and the position of the half-value on the long-wavelength side shifts to the short-wavelength side.

Figure 5 shows a relation between an angle of incidence on the optical filter 5 and the transmissivity. A solid line, dashed line, and two-dot chain line in the figure indicate the transmissivity characteristic at the angle of incidence 0, 10, and 20 degrees, respectively, on the optical filter 5. As seen in Figure 5, when the angle of incidence was changed to 10 and 20 degrees, the position of the half-value on the long-wavelength side shifted about 5 nm and 10 nm, respectively, to the short-wavelength side compared to the angle of incidence 0 degree, and specifically reached 745 nm and 740 nm. An image quality evaluation showed that the 10 nm change caused a sense of incongruity visually, and that the image quality deteriorated visually.

In order to achieve reduction in thickness, the angle of incidence has to be large on the surrounding pixels. So, apertures of surrounding pixels of the semiconductor imaging device where the angle of incidence on the optical filter 5 is larger are increased in diameter compared to the near center, so that image degradation with the surrounding pixels caused by the increase in the angle of incidence can be reduced.

A method to determine the diameter of the apertures for this case is, for example, to determine a diameter of apertures of surrounding pixels of the semiconductor imaging device 4 which reduces the influence of the angle of incidence, to determine a diameter of apertures to which the degradation in sensitivity caused by the wave nature is corrected, and then to perform optimization as a whole. Conversely, a diameter of the apertures may first be determined as a whole, and then a correction may be made to the surrounding pixels. The method to determine the diameter of the apertures can be changed as appropriate in accordance with properties of the imaging apparatus.

When the pixel size is miniaturized to about 1 µm, apertures need be changed also for the output from B pixels. In this case, apertures are given so as to balance each sensitivity ratio of R, G, and B. If each sensitivity ratio of R, G, and B is balanced, the decrease in sensitivity of the semiconductor imaging device 4 as a whole can be handled with an increase in sensitivity or optimization of exposure time of the photodiode 56 itself, or with an increase in gain on the reading circuit side, etc. This can achieve reduction in size and thickness of the imaging apparatus.

### (Second embodiment)

A second embodiment of the invention will be described next. An imaging apparatus of the second embodiment is configured basically the same as the imaging apparatus 1 of the first embodiment, but is different in that its three-dimensional substrate 2 does not transmit visible light and near infrared light. This configuration in which visible light and near infrared light are not transmitted means a kind of configuration in which image quality is not substantially degraded. Specifically, the transmissivity should be about 0.5% or less, preferably 0.2% or less. It is about 0.15% in the embodiment.

The semiconductor imaging device 4 is made of silicon. Therefore, an upper limit of its sensitivity range on the long-wavelength side depends on a wavelength at which the band gap energy of silicon (Eg) is exceeded. The band gap energy of silicone is about 1.12 eV, and the wavelength limit is determined by λ≒1240/Eg, where the wavelength is A [nm], the band gap energy is Eg [eV]. Consequently, the limit of sensitivity on the long-wavelength side is about 1100 nm (1.1 µm), which is a far-infrared ray.

The three-dimensional substrate 2 of the embodiment comprises a resin material (PAA) added with highly dispersible carbon black, which is effective for visible light and the short-wavelength side, and with borosilicate glass, which absorbs ultraviolet light. The three-dimensional substrate 2 may also have about 2 wt% of aluminum mixed as a thermally conductive metal filler. This allows the transmissivity of visible light and near infrared light to be sufficiently low for the sensitivity range of the semiconductor imaging device 4. Image degradation is evaluated so as to optimize material thickness of the resin of the three-dimensional substrate. Since near infrared light, which is of long wavelength, tends to permeate deeper, it is important to consider this point carefully, If near infrared light of a wavelength of 1.1 *µ*m or less enters the semiconductor imaging device 4, noise occurs and image quality is degraded. In order to prevent this, it is effective to increase the amount of the metal filler to be mixed to the resin material. Incidentally, when aluminum is used as the metal filler, it is preferable to use aluminum in the form of aluminum oxide (alumina, Al₂O₃) in order not to lower the electrical insulation resistance.

Since the three-dimensional substrate 2 of the embodiment has the construction that does not transmit visible light and near infrared light, the embodiment can be implemented in a portable telephone or other equipment without being provided with a light shield member for shielding unnecessary light to the imaging apparatus 1. This increases a degree of flexibility in designing portable equipment, achieves size reduction of the equipment, and also achieves improvement of convenience.

### (Third embodiment)

An imaging apparatus of a third embodiment is configured basically the same as the semiconductor imaging apparatus 1 of the first embodiment described with reference to Figures 2 to 5.

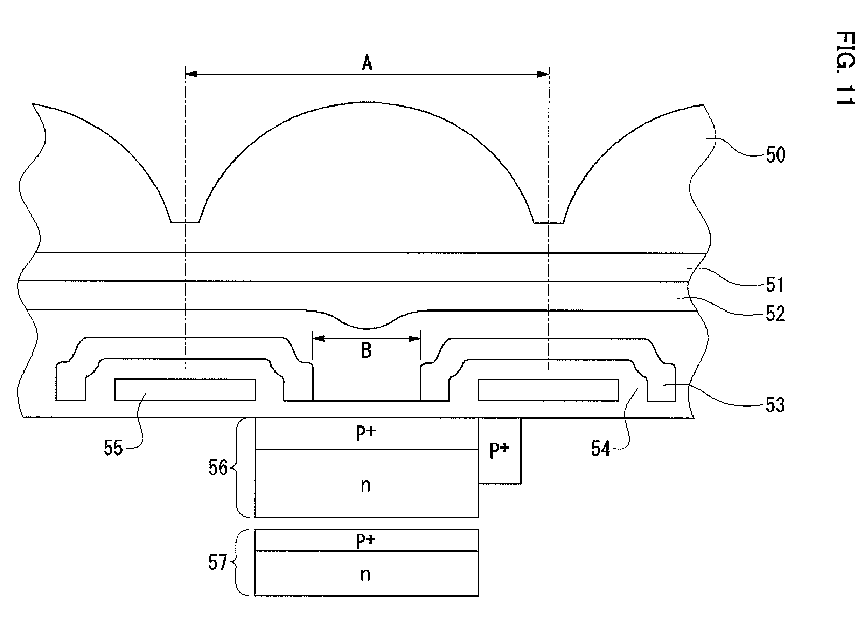

Figure 11 is an enlarged view showing one pixel of a semiconductor imaging device 4. The semiconductor imaging device 4 is configured basically the same as the semiconductor imaging device 4 of the first embodiment described by Figure 6. As shown in Figure 11, the semiconductor imaging device 4 comprises a photodiode 56 and a photodiode 57. A microlens 50, a color filter 51, an inner lens and protection film 52, an Al wiring and mask 53, an insulating layer 54, polysilicon 55, and the like are provided on the light incident side of a photodiode 56.

The photodiodes 56 and 57 are arranged such that each incident surface faces in the same direction. The photodiode 57 is placed on the opposite side of the incident surface of the photodiode 56, and is an auxiliary photodiode for detecting light that has passed through the photodiode 56. Photodiodes of the same type are used as the photodiodes 56 and 57. While photodiodes of the same type are used as the photodiodes 56 and 57 in the embodiment, photodiodes which are different from each other in properties, form, or the like may be used as the photodiodes 56 and 57.

Outputs from the photodiodes 56 and 57 are added to each other and led to a reading circuit not shown in the figure. The reading method is to send an electrical charge horizontally and vertically, as in the case of conventional ones. This configuration can derive outputs from the photodiodes 56 and 57.

The size of the photodiode 57 is determined in accordance with a wavelength of light transmitted by the color filter 51 provided on the incident side of the photodiode 56. A large photodiode 57 is used if the provided color filter 51 transmits long-wavelength light, and a small photodiode 57 is used if the provided color filter 51 transmits short-wavelength light. The photodiode 57 may need not be provided if the provided color filter 51 transmits short-wavelength light.

The sensitivity characteristic shown in Figure 8 indicates that, when the pixel size is 1.5 µm, the sensitivity to 650 nm which is near the center of the sensitivity of R decreases by about 15%, and the sensitivity to 550 nm which is near the center of the sensitivity of G decreases by about 5%. In the embodiment, the size of the photodiode 57 is set so as to compensate the decrease in sensitivity due to reduction of the pixel size. For example, the photodiode 57 of a large size is put on the photodiode 56 provided with the color filter 51 which transmits large-decrease-in-sensitivity R (650 nm), and the photodiode 57 of a small size is put on the photodiode 56 provided with the color filter 51 which transmits small-decrease-in-sensitivity G (550 nm). The large size photodiode 57 has a higher sensitivity than the small size photodiode 57, and therefore can compensate the decrease in sensitivity to a large extent. In this way, the sum total of outputs from the photodiodes 56 and 57 is maintained constant.

Generally, long-wavelength light reaches deeper in the semiconductor imaging device. So, the longer the wavelength of light is, which is susceptible to wave motion, the larger the output can be derived from the photodiode 57. Short-wavelength light hardly reaches the photodiode 57, but on the other hand is not so susceptible to wave motion, so that a large output is outputted from the photodiode 56. Based on this correlation, variations in the output obtained from the photodiodes 56 and 57 may be determined to optimize the size of the photodiode 57.

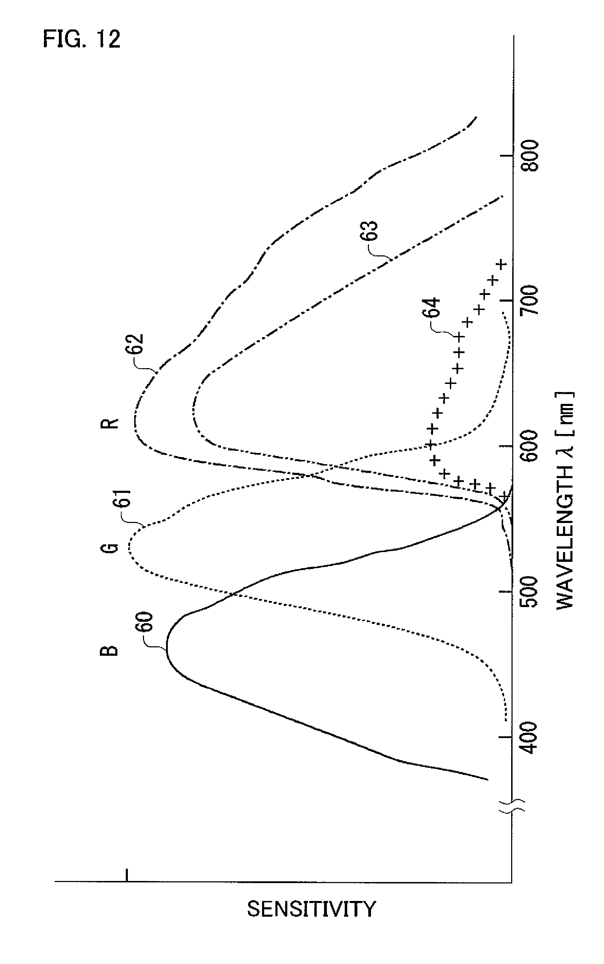

Figure 12 shows a sensitivity characteristic of the semiconductor imaging device 4 of the embodiment versus wavelength λ for each primary color (R, G, and B) pixel. The horizontal axis represents wavelength, and the vertical axis represents the sensitivity. This photodiode is made of silicone and is sensitive up to the near infrared light region. The figure shows the sensitivity to blue (spectral sensitivity) 60 at the pixel size of 2.5 *µ*m, and shows in the same way the sensitivity to green 61 and the sensitivity to red 62. The figure also shows an output 63 from the photodiode 56 and an output 64 from the photodiode 57 for red at the pixel size of 1.5 µm. There is some difference in spectral characteristics between the output 63 from the photodiode 56 and the output 64 from the photodiode 57. A reason for this is thought that shorter-wavelength components are more attenuated to reach the photodiode 57 on the underside.

As shown in Figure 12, the photodiode 56 is sensitive up to the near infrared light region. Since long-wavelength light is hard to attenuate, consideration is required also for light entering from the backside of the device. In the embodiment, the metallic foil 14 provided on the backside of the FPC 15 prevents the entrance of visible light and infrared light. As for sensitivities to each color, sensitivity characteristic values are integrated and compared. The sensitivities vary depending on properties of color filters, characteristics of pigmentary coloring matter to be used, and the like. The above is a description of a configuration of the imaging apparatus 1 of the embodiment.

Advantages of the imaging apparatus 1 of the embodiment will be described in the following. As described in the above embodiment, there is a background that the relative sensitivity to long wavelengths tends to decrease remarkably as the pixel size gets smaller, and that the image degradation problem is expected to surface because of the further size reduction in the future.

In the imaging apparatus 1 of the embodiment, the photodiode 57 is placed on the opposite side of the incident surface of the photodiode 56. This allows light incident on the semiconductor imaging device 4 to be detected by both photodiodes 56 and 57, and the detected signals are added to each other. Consequently, the sensitivity of the semiconductor imaging device 4 can be increased.

In the imaging apparatus 1 of the embodiment, the size of the photodiode 57 is determined in accordance with a wavelength of light transmitted by the color filter 51 provided on the incident surface side of each photodiode 56. That is, for the photodiode 57 provided with the color filter 51 which transmits long-wavelength light, the wave-optics effect is compensated by increasing the sensitivity, so that a property which is seen as if there is no decrease in sensitivity can be realized.

As can be seen from Figure 12, the decrease in sensitivity of the photodiode 56 is compensated by adding the output 63 from the photodiode 56 and the output 64 from the photodiode 57, so that a signal can be derived which is comparable to that from a red pixel of a size of 2.5 µm, that is, at the same level as a state in which there is almost no decrease in output. The decrease in output from a green pixel can also be compensated in a like manner.

In the imaging apparatus 1 of the embodiment, photodiodes of the same type are used as the photodiodes 56 and 57, and the photodiodes 56 and 57 can both be photoelectrically converted by the same method. Therefore, there is an advantage that conventional circuits and various corrections, and the like can be used as they are.

The semiconductor imaging device of the embodiment uses a Bayer-arrangement array, and therefore conventional techniques such as a reading method, color correction, and interpolation can be applied. Consequently, the efficiency of development can be improved, and various know-how can also be inherited and applied.

The embodiment can comprise the three-dimensional substrate 2 that does not transmit visible light and near infrared light, as with the above-described second embodiment. This allows the embodiment, as with the second embodiment, to be implemented in a portable telephone or other equipment without being provided with a light shield member for shielding unnecessary light to the imaging apparatus 1. This increases a degree of flexibility in designing portable equipment, achieves size reduction of the equipment, and also achieves improvement of convenience.

The following variations can also be made to the third embodiment. While an example in which the two photodiodes 56 and 57 are used has been described in the above embodiment, still another photodiode can be added to the underside of the photodiode 57 for a pixel corresponding to long-wavelength red.

When the pixel size is miniaturized to about 1 µm, it is preferable to provide the photodiode 57 for every pixel corresponding to R, G, and B. It is also desirable to select the sensitivity so as to balance each sensitivity ratio of R, G, and B. This can achieve reduction in size and thickness of the imaging apparatus.

In consideration that the half-value wavelength on the long-wavelength side shifts in value to the short-wavelength side in accordance with the angle of incidence on the optical filter 5, there may be a configuration in which the sensitivity of surrounding pixels of the semiconductor imaging device 4 where the angle of incidence on the optical filter 5 is larger is increased compared to the near center. As described before, the angle of incidence has to be large on the surrounding pixels in order to achieve reduction in thickness, and the increase in the angle of incidence makes the position of the half-value on the long-wavelength side, in the surroundings, shift to the short-wavelength side.

So, the sensitivity of surrounding pixels of the semiconductor imaging device where the angle of incidence on the optical filter 5 is larger is increased compared to the near center, so that image degradation with the surrounding pixels caused by the increase in the angle of incidence can be reduced.

A method to determine the sensitivity for this case is, for example, to determine a decrease in sensitivity of the surrounding pixels of the semiconductor imaging device 4 caused by the influence of the angle of incidence, to determine the sensitivity to which the degradation in sensitivity is corrected, and then to perform optimization as a whole. Conversely, the sensitivity may first be determined as a whole, and then a correction may be made to the surrounding pixels. The method to determine the sensitivity can be changed as appropriate in accordance with properties of the imaging apparatus.

### (Fourth embodiment)

An imaging apparatus of a fourth embodiment is configured basically the same as the semiconductor imaging apparatus 1 of the first embodiment described with reference to Figures 2 to 5.

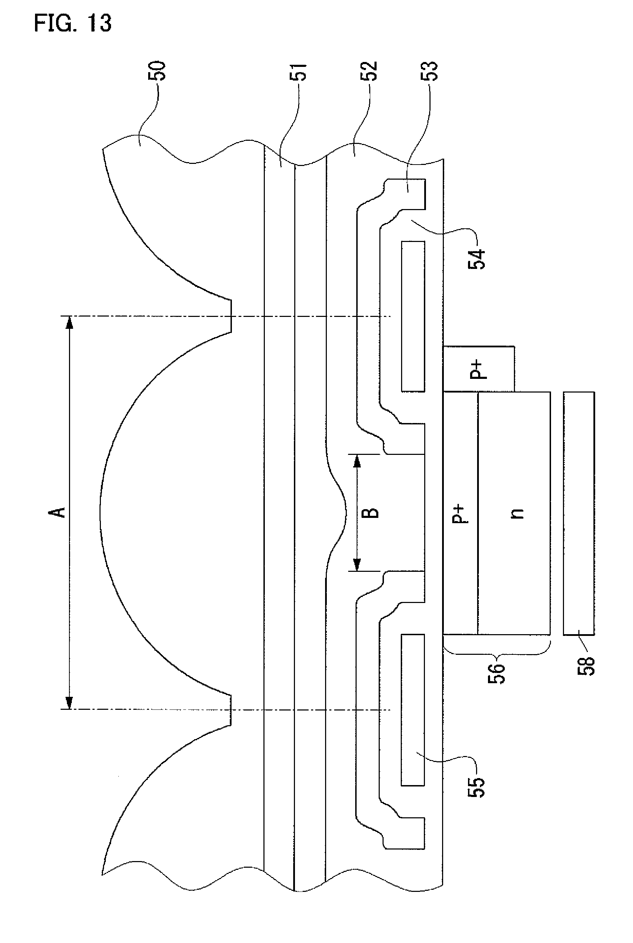

Figure 13 is an enlarged view showing one pixel of a semiconductor imaging device 4. The semiconductor imaging device 4 is configured basically the same as the semiconductor imaging device 4 of the first embodiment described by Figure 6. As shown in Figure 13, the semiconductor imaging device 4 comprises a photodiode 56 that converts incident light to an electrical signal.

A microlens 50, a color filter 51, an inner lens and protection film 52, an Al wiring and mask 53, an insulating layer 54, polysilicon 55, and the like are provided on the light incident side of a photodiode 56. The semiconductor imaging device 4, on an opposite side of an incident surface of the photodiode 56, has a reflective layer 58 for reflecting in the direction of the photodiode 56 light that has passed through the photodiode 56.

Aluminum is used for the reflective layer 58 as a silvery-white metal. Aluminum is often used for semiconductors as electrodes and internal wiring, and is therefore easy to use. Its low density realizes a light weight, and the unit price is lower than other silvery-white metals. While aluminum is used in the embodiment, other silvery-white metals such as nickel, titanium, or the like can also be used. If nickel is used, the photodiode 56 can be electromagnetically shielded, and this function is advantageous over EMI or the like. The material of the reflective layer, or the thickness and size as a reflective film can be selected as appropriate so that a required reflectance is obtained.

The size and reflectance of the reflective layer 58 are determined in accordance with a wavelength of light transmitted by the color filter 51 provided on the incident surface side of the photodiode 56. A reflective layer 58 of a large size and reflectance is used if the provided color filter 51 transmits long-wavelength light, and a reflective layer 58 of a small size and reflectance is used if the provided color filter 51 transmits short-wavelength light. The reflective layer 58 may need not be comprised if the provided color filter 51 transmits short-wavelength light. While in the embodiment the size and reflectance of the reflective layer 58 are determined in accordance with a wavelength of light transmitted by the color filter 51, the change of the reflective layer 58 may be in size only or in reflectance only.

The sensitivity characteristic shown in Figure 8 indicates that, when the pixel size is 1.5 µm, the sensitivity to 650 nm which is near the center of the sensitivity of R decreases by about 15%, and the sensitivity to 550 nm which is near the center of the sensitivity of G decreases by about 5%. In the embodiment, the size and reflectance of the reflective layer 58 are set so as to compensate the decrease in sensitivity due to reduction of the pixel size. For example, the reflective layer 58 of a large size and reflectance is put on the photodiode 56 provided with the color filter 51 which transmits large-decrease-in-sensitivity R (650 nm), and the reflective layer 58 of a small size and reflectance is put on the photodiode 56 provided with the color filter 51 which transmits small-decrease-in-sensitivity G (550 nm). The larger the size and reflectance of the reflective layer 58 are, the higher the sensitivity of the photodiode 56 is.

Generally, long-wavelength light reaches deeper in the semiconductor imaging device. So, the longer the wavelength of light is, which is susceptible to wave motion, the larger the amount of light reflected from the reflective layer 58 is. Short-wavelength light reaches the reflective layer 58 in small amounts, but on the other hand is not so susceptible to wave motion, so that a large output can be obtained by light incident from the incident surface side of the photodiode 56. Based on this correlation, variations in the output obtained by light reflected from the reflective layer 58 may be determined to optimize the size and reflectance of the reflective layer 58.

The photodiode 56 photoelectrically converts light incident from the incident surface side provided with the color filter 51 and light reflected by the reflective layer 58, and outputs an electrical signal. The output from the photodiode 56 is led to a reading circuit not shown in the figure. The reading method is to send an electrical charge horizontally and vertically, as in the case of conventional ones. This configuration can derive outputs from the photodiode 56.

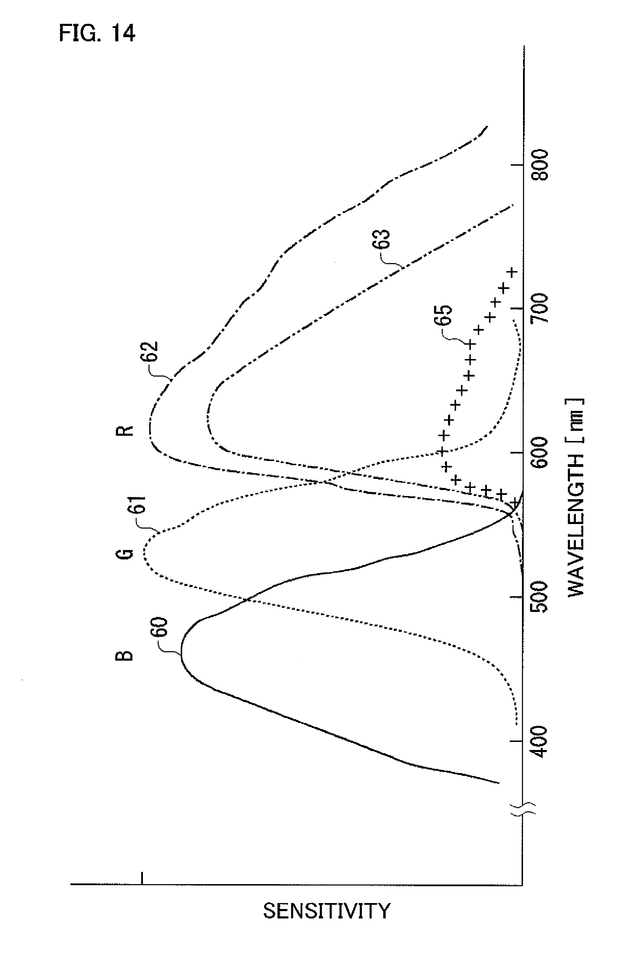

Figure 14 shows a sensitivity characteristic of the photodiode 56 versus wavelength. The horizontal axis represents wavelength, and the vertical axis represents the sensitivity. This photodiode is made of silicone and is sensitive up to the near infrared light region. The figure shows the sensitivity to blue (spectral sensitivity) 60 at the pixel size of 2.5 µm, and shows in the same way the sensitivity to green 61 and the sensitivity to red 62. The figure also shows an output 63 from the photodiode 56 and an output 65 from the photodiode obtained from light reentering from the reflective layer 58 for red at the pixel size of 1.5 µm. There is some difference in spectral characteristics between the output 63 from the photodiode 56 and the output 65 obtained from light reentering from the reflective layer 58. A reason for this is thought that shorter-wavelength components are more attenuated to reach the reflective layer 58.

As shown in Figure 14, the photodiode 56 is sensitive up to the near infrared light region. Since long-wavelength light is hard to attenuate, consideration is required also for light entering from the backside of the device. In the embodiment, the metallic foil 14 provided on the backside of the FPC 15 prevents the entrance of visible light and infrared light. As for sensitivities to each color, sensitivity characteristic values are integrated and compared. The sensitivities vary depending on properties of color filters, characteristics of pigmentary coloring matter to be used, and the like. The above is a description of a configuration of the imaging apparatus 1 of the embodiment.

Advantages of the imaging apparatus 1 of the embodiment will be described in the following. As described in the above embodiment, there is a background that the relative sensitivity to long wavelengths tends to decrease remarkably as the pixel size gets smaller, and that the image degradation problem is expected to surface because of the further size reduction in the future.

In the imaging apparatus 1 of the embodiment, the reflective layer 58 is placed on the opposite side of the incident surface of the photodiode 56. This allows light that has passed through the photodiode 56 to be reflected by the reflective layer 58 and to reenter the photodiode 56. Consequently, the sensitivity of the photodiode 56 can be increased.

In the imaging apparatus 1 of the embodiment, the size and reflectance of the reflective layer 58 is determined in accordance with a wavelength of light transmitted by the color filter 51 provided on the incident surface side of each photodiode 56. That is, where the color filter 51 which transmits long-wavelength light is provided, the reflective layer 58 of a large size and reflectance is used, so that the amount of reflected light is increased and the sensitivity of the photodiode 56 is increased. In this way, for the photodiode sensitive to long-wavelength light, the wave-optics effect is compensated, so that a property which is seen as if there is no decrease in sensitivity can be realized.

As can be seen from Figure 14, by adding the output 63 from the photodiode 56 and the output 65 obtained by the reflective layer 58, the output can be derived which is comparable to that from a red pixel of a size of 2.5 µm, that is, in a state where there is almost no decrease in output. In a like manner, the decrease in output from a green pixel can also be reduced by light reentering from the reflective layer 58..

The semiconductor imaging device of the embodiment uses a Bayer-arrangement array, and therefore conventional techniques such as a reading method, color correction, and interpolation can be applied. Consequently, the efficiency of development can be improved, and various know-how can also be inherited and applied.

The embodiment can comprise the three-dimensional substrate 2 that does not transmit visible light and near infrared light, as with the above-described second embodiment. This allows the embodiment, as with the second embodiment, to be implemented in a portable telephone or other equipment without being provided with a light shield member for shielding unnecessary light to the imaging apparatus 1. This increases a degree of flexibility in designing portable equipment, achieves size reduction of the equipment, and also achieves improvement of convenience.

The following variations can also be made to the fourth embodiment. While an example in which a silvery-white metal is used as the reflective layer 58 has been described in the above embodiment, the reflective layer 58 may be formed of a semiconductor. The semiconductor reflective layer can be obtained by stacking films of optical refractive indices varying depending on doping materials so as to form a multilayer. As another method, a polysilicon layer can be used not as an electrically conductive film but as the reflective film. The refractive index, the number of layers of the film, the reflectance, and the like can be selected as appropriate.

When the pixel size is miniaturized to about 1 *µ*m, it is preferable to provide the reflective layer 58 for every pixel corresponding to R, G, and B. It is also desirable to select the sensitivity so as to balance each sensitivity ratio of R, G, and B. This can achieve reduction in size and thickness of the imaging apparatus.

In consideration that the half-value wavelength on the long-wavelength side shifts in value to the short-wavelength side in accordance with the angle of incidence on the optical filter 5, there may be a configuration in which the sensitivity of surrounding pixels of the semiconductor imaging device 4 where the angle of incidence on the optical filter 5 is larger is increased compared to the near center. As described before, the angle of incidence has to be large on the surrounding pixels in order to achieve reduction in thickness, and the increase in the angle of incidence makes the position of the half-value on the long-wavelength side, in the surroundings, shift to the short-wavelength side.

So, the sensitivity of surrounding pixels of the semiconductor imaging device where the angle of incidence on the optical filter 5 is larger is increased compared to the near center, so that image degradation with the surrounding pixels caused by the increase in the angle of incidence can be reduced.

A method to determine the sensitivity for this case is, for example, to determine a decrease in sensitivity of the surrounding pixels of the semiconductor imaging device 4 caused by the influence of the angle of incidence, to determine the sensitivity to which the degradation in sensitivity is corrected, and then to perform optimization as a whole. Conversely, the sensitivity may first be determined as a whole, and then a correction may be made to the surrounding pixels. The method to determine the sensitivity can be changed as appropriate in accordance with properties of the imaging apparatus.

While there has been described what are at present considered to be preferred embodiments of the invention, it will be understood that various modifications and variations may be made thereto, and it is intended that appended claims cover all such modifications and variations as fall within the true spirit and scope of the invention.

### Industrial applicability

The invention is useful as a portable terminal, a portable telephone, or the like provided with an imaging apparatus using a semiconductor imaging device.

## Claims

1. An imaging apparatus comprising:
a semiconductor imaging device having a plurality of photodiodes and a color filter; and
an imaging optical system for guiding light from a subject to the semiconductor imaging device,
wherein a diameter of an aperture of each photodiode of the semiconductor imaging device is determined in accordance with a wavelength of light that passes through a color filter provided on an incident surface side of the photodiode and reaches the incident surface.

2. The imaging apparatus according to claim 1, comprising an optical filter placed between the semiconductor imaging device and the imaging optical system,
wherein a diameter of an aperture of each photodiode of the semiconductor imaging device is determined in accordance with an angle of incidence of light that enters an area on the optical filter corresponding to the photodiode.

3. The imaging apparatus according to claim 1 or 2, wherein pixels on a same line of the semiconductor imaging device are equal in height.

4. An imaging apparatus comprising:
a semiconductor imaging device having a plurality of photodiodes and a color filter; and
an imaging optical system for guiding light from a subject to the semiconductor imaging device,
wherein the semiconductor imaging device, on an opposite side of an incident surface of at least part of the plurality of photodiodes, has an auxiliary photodiode for detecting light that has passed through the photodiode.

5. The imaging apparatus according to claim 4, wherein a size of the auxiliary photodiode is determined in accordance with a wavelength of light that passes through the color filter provided on an incident surface side of the photodiode and reaches the incident surface.

6. The imaging apparatus according to claim 4 or 5, comprising an optical filter placed between the semiconductor imaging device and the imaging optical system,
wherein a size of the auxiliary photodiode is determined in accordance with an angle of incidence of light that enters an area on the optical filter corresponding to the photodiode.

7. An imaging apparatus comprising:
a semiconductor imaging device having a plurality of photodiodes and a color filter; and
an imaging optical system for guiding light from a subject to the semiconductor imaging device,
wherein the semiconductor imaging device, on an opposite side of an incident surface of at least part of the plurality of photodiodes, has a reflective layer for reflecting light that has passed through the photodiode.

8. The imaging apparatus according to claim 7, wherein a size or reflectance of the reflective layer is determined in accordance with a wavelength of light that passes through the color filter provided on an incident surface side of the photodiode and reaches the incident surface.

9. The imaging apparatus according to claim 7 or 8, wherein the reflective layer is formed of a silvery-white metal.

10. The imaging apparatus according to claim 7 or 8, wherein the reflective layer is formed of a semiconductor.

11. The imaging apparatus according to any one of claims 7 to 10, comprising an optical filter placed between the semiconductor imaging device and the imaging optical system,
wherein a size or reflectance of the reflective layer is determined in accordance with an angle of incidence of light that enters an area on the optical filter corresponding to the photodiode.

12. The imaging apparatus according to any one of claims 1 to 11, comprising a three-dimensional substrate for containing the semiconductor imaging device, the three-dimensional substrate not transmitting visible light and near infrared light.

13. The imaging apparatus according to any one of claims 1 to 12, wherein a pixel pitch of the semiconductor imaging device is 2 micrometers or less.

14. A portable telephone apparatus comprising the imaging apparatus according to any one of claims 1 to 13.

15. A semiconductor imaging device comprising:
a plurality of photodiodes for converting incident light to an electrical signal; and
a color filter provided on an incident surface side of a photodiode,
wherein a diameter of an aperture of each of the photodiodes is determined in accordance with a wavelength of light that passes through the color filter provided on an incident surface side of the photodiode and reaches the incident surface.

16. A semiconductor imaging device comprising:
a plurality of photodiodes for converting incident light to an electrical signal;
a color filter provided on an incident surface side of a photodiode; and
an auxiliary photodiode placed on an opposite side of an incident surface of at least part of the plurality of photodiodes, the auxiliary photodiode having a size according to a wavelength of transmitted light incident from the color filter to the photodiode.

17. A semiconductor imaging device comprising:
a plurality of photodiodes for converting incident light to an electrical signal;
a color filter provided on an incident surface side of a photodiode; and
a reflective layer placed on an opposite side of an incident surface of at least part of the plurality of photodiodes, the reflective layer having a size or reflectance according to a wavelength of transmitted light incident from the color filter to the photodiode.
